# EUROPEAN PATENT APPLICATION

(11) **EP 2 503 697 A1**
(43) Date of publication of application: **26.09.2012**
(21) Application number: 11159235.8
(22) Date of filing: 22.03.2011
(51) Int. Cl.: H03M 7/30

(54) **Method and apparatus for data compression**

(71) Applicant: Pii Limited, Cramlington, Northumberland NE23 1WW (GB)
(72) Inventor: Man, Ying, Northumberland NE23 1WW (GB)
(74) Representative: McWilliams, David John

(57) **Abstract**

A method of data compression comprising dividing a stream of sequentially received-generated data coefficients into multiple sets of data coefficients, each set of the data coefficients representing a time period and for each set selecting N data coefficients having the greatest magnitude and ordering the N data coefficients according to their magnitude; for each N ordered data coefficients, selecting a subset of data coefficients having a magnitude greater than a threshold value; comparing the data coefficient with the greatest magnitude from each subset to one another and selecting the Q largest data coefficients; repeating the previous comparison step excluding the previously selected Q data coefficients until a total of P data coefficients have been selected, where N > P > Q.

## Description

### BACKGROUND TO THE INVENTION

Fluid transmission pipelines, such as gas pipelines, are susceptible to stress corrosion cracking that can result in in-service failures occurring. The need to detect the presence of such cracking at an early stage before it develops into deep cracking that can subsequently result in a total failure is therefore important to the pipeline operators. One method of performing such detection is the use of complex intelligent inspection tools that travel inside the pipe whilst the pipe is still operating in service. An example of such a tool is the Elastic Wave Cracking Detection tool owned and operated by the current applicants. This tool uses ultrasonic non-destructive testing principles to locate stress corrosion cracks within a pipeline. The tool includes a number of ultrasonic transducers that are arranged to inject ultrasound waves into the pipe wall at an angle such that they travel circumferentially around the pipe. When the ultrasound waves encounter an axial crack or other defect within the pipe wall the waves are reflected and the echo is detected by the transducers. The ultrasound transducers are arranged in staggered arrays and the tool may travel down the pipeline at speeds of up to 6.7mph. Consequently large volumes of data are generated for subsequent analysis. This very large volume of data can in itself present difficulties in performing the data analysis.

### SUMMARY OF THE INVENTION

According to a first aspect of the present invention there is provided a method of data compression comprising:
dividing a stream of sequentially received-generated data coefficients into multiple sets of data coefficients, each set of the data coefficients representing a time period and for each set selecting N data coefficients having the greatest magnitude and ordering the N data coefficients according to their magnitude;
for each N ordered data coefficients, selecting a subset of data coefficients having a magnitude greater than a threshold value;
comparing the data coefficient with the greatest magnitude from each subset to one another and selecting the Q largest data coefficients;
repeating the previous comparison step excluding the previously selected Q data coefficients until a total of P data coefficients have been selected, where N > P > Q.

The threshold value may be a predetermined value or may be a percentage of the R.M.S value of the data coefficients.

Any two of the sets of data coefficients representing sequential time periods may have a plurality of data coefficients in common, the common coefficients in each set representing an overlapping portion of the time periods.

The data coefficients may comprise wavelet coefficients. In which case the wavelet coefficients may be generated by performing a Discrete Wavelet Transformation on a digital data stream. The digital data stream may be derived from the output of one or more electro-magnetic sensors. The electro-magnetic sensors may comprise ultrasonic or magnetic sensors. The digital data stream may be generated by a pipeline inspection tool having one or more of said sensors.

According to a second aspect of the present invention there is provided a computer program comprising computer executable instructions that when executed by a computer cause the computer to perform the method of the first aspect of the present invention.

According to a third aspect of the present invention there is provided apparatus for performing data compression comprising a data processor arranged to perform the method of the first aspect of the present invention.

According to a forth aspect of the present invention there is provided a pipeline inspection tool comprising at least one electro-magnetic sensor assembly arranged to generate a digital data stream, a coefficient module arranged to receive the digital data stream and output a stream of data coefficients, and a data processor arranged to perform the data compression method of the first aspect of the present invention.

### BRIEF DESCRIPTION OF THE DRAWINGS

The embodiments of the invention will now be described, by way of non-limiting example only, with reference to the accompanying figures, in which:
Figure 1 schematically illustrates an implementation of Discrete Wavelet Transformation;
Figures 2a and 2b schematically illustrate an implementation for selecting the N-highest wavelet coefficients generated by the transform of Figure 1; and
Figures 3a - 3d schematically illustrate a wavelet coefficient selection scheme in accordance with the present invention.

### DESCRIPTION OF EMBODIMENTS OF THE INVENTION

As noted above, it is known to inspect pipelines using devices that travel through the interior of the pipeline (commonly referred to as "pigs") having multiple ultrasonic or magnetic transducers that function to collect large volumes of data. Typically, the analog output from each of the transducers is transmitted to one or more pre-processing electronic modules, that typically include one or more analog-to-digital converters, digital filters and digital signal processors, to convert the analog signals from the transducers into a single digital data stream that can be provided for further processing and data analysis. The digital data stream is typically stored locally on the inspection device, for example using one or more hard disk drives, and subsequently retrieved after the section of pipeline of interest has been inspected by the device for subsequent data processing and analysis.

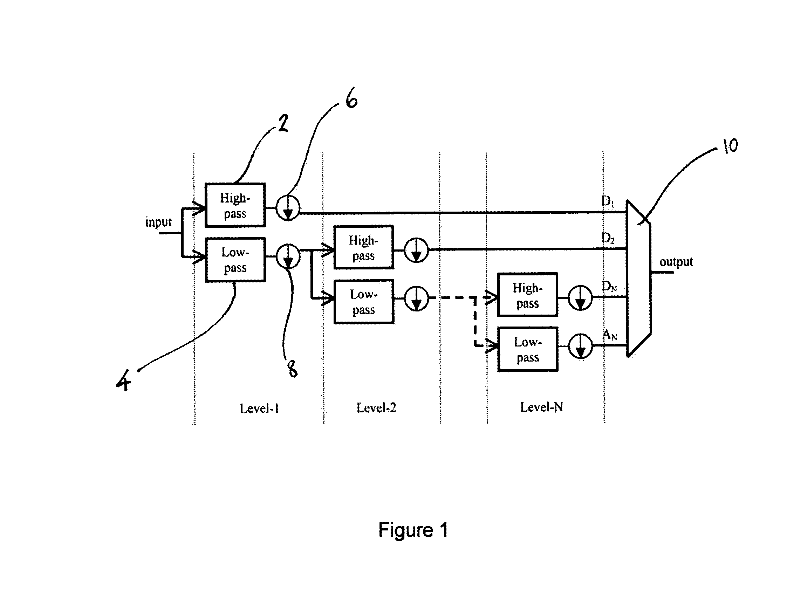

Because of the potentially large volume of digital data to be stored it is desirable to apply some form of data compression to the digital data before storage. Various data compression schemes are suitable to compress the data to be stored, as will be understood by the person skilled in the art. One such compression scheme is wavelet compression, which transforms a digital data stream into a number of wavelet coefficients. Figure 1 schematically illustrates a possible implementation method for performing wavelet transformation. In the implementation method illustrated in Figure 1 the wavelet transformation is performed using an N-stage discrete wavelet transformation. However, it will be appreciated that other wavelet transforms can be used. With reference to Figure 1, each of the N-levels includes a high pass digital filter 2 and a low pass digital filter 4. The input to both filters for the first level is the raw digitised sensor signal (the digital data stream output by the pre-processing modules previously mentioned). The output of the high pass digital filter for each level is down sampled by a factor of 2 by corresponding down samplers 6 and subsequently provided as separate inputs to a multiplexer 10. The output from each of the low pass digital filters 4 at each level is also down sampled by a factor of 2 by a corresponding down sampler 8 before being provided as the input to both the high pass digital filter and low pass digital filter of the next level. The output of the final low pass digital filter for the Nth level is provided as an additional input to the multiplexer 10. The output of the high pass filters are referred to as the detail coefficients, whilst the output of the low pass filters are referred to as the approximation coefficients. The output timing of the multiplexer 10 is controlled by a set of counters, with each counter being associated with one decomposition level. For a three-stage discrete wavelet transformation the output of the multiplexer 10 will be a sequence of time-multiplexed wavelet coefficients as follows:
...A3, D1, D2, D1, D3, D1, D2, D1, A3, D1, D2, D1, D3, D1, D2, D1, A3...

The wavelet coefficients output from the multiplexer have both a magnitude and an associated time position, the time position being related to a point in time of the ultrasonic scanning process and therefore being able to be used to identify a position within the pipeline that the wavelet coefficient is associated with. The data gathered by the ultrasonic inspection tool during a single inspection event is typically subdivided into a number of sequential scans to facilitate the subsequent analysis steps.

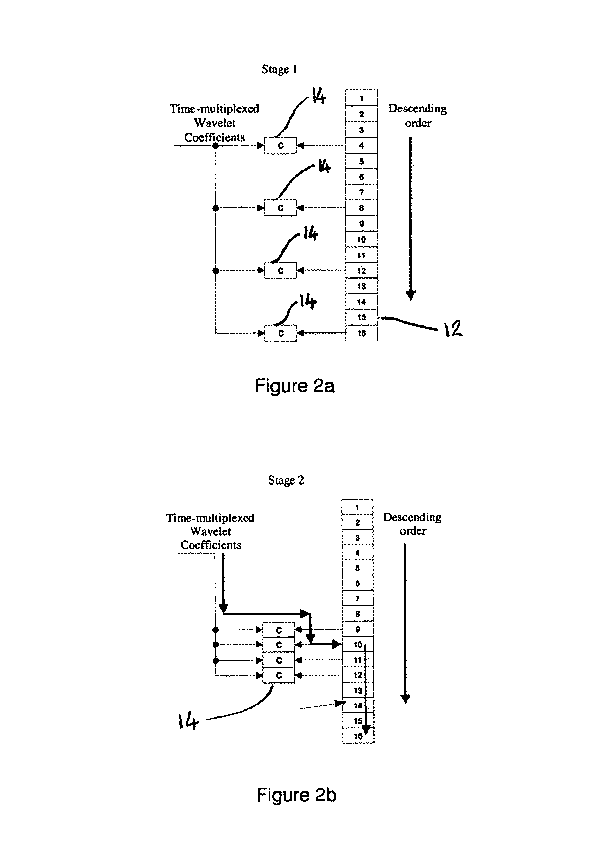

To further reduce the amount of data to be stored during each scan, a process of wavelet coefficient selection may be performed on the wavelet coefficients output from the multiplexer 10 of the discrete wavelet transformation module. The wavelet coefficient selection process may comprises selecting the N-highest wavelet coefficients. Figures 2a and 2b schematically illustrates how the 16-highest wavelet coefficients output from the multiplexer 10 during any given scan can be selected and ordered into descending magnitude. Referring to Figure 2a, sixteen individual registers 12 or memory locations are provided to each store a wavelet coefficient magnitude value and associated time position. The registers are divided into multiple bands, the example illustrated in Figure 2a having four such bands with four registers per band. In the first stage, represented in Figure 2a, four individual comparators 14 are configured such that each comparator receives as an input the coefficient value stored in the lowest register for each respective band. Each wavelet coefficient output from the multiplexer 10 is provided as a second input to each of the four comparators 14. If the value of the wavelet coefficient output from the multiplexer is greater than the already stored wavelet coefficient provided as a second input to the respective comparators, then the output wavelet coefficient must fall within the register band associated with that particular comparator. For example, with reference to Figure 2a, if the wavelet coefficient output from the multiplexer 10 and provided as a second input to each of the comparators 14 has a magnitude less than the magnitude of the coefficients stored in registers 4 or 8 but greater than that of the coefficient stored in register 12, then it can be determined that the wavelet coefficient output from the multiplexer belongs in the third band formed by registers 9-12. Figure 2b schematically illustrates the subsequent stage in which the exact insertion point for the selected coefficient is determined by comparing its magnitude to that of the previously selected coefficients in each of the registers within the appropriate band. In other words, the comparators 14 are re-configured so as to receive as an input a respective one of the coefficients stored in the registers in the selected band, in the example shown in figure 2b registers 9-12, whilst the wavelet coefficient output from the multiplexer is again provided as a second input to each of the comparators. The newly selected wavelet coefficient will be inserted into the register for which the new coefficient has a greater magnitude than the coefficient previously stored in that register. In Figure 2b this is register 10. The wavelet coefficients previously stored in the lower registers, i.e. registers 10-16 are re-allocated to the next lower register, with the coefficient having the lowest magnitude, i.e. that previously stored in register 16, being discarded. In this fashion, as each wavelet coefficient is output from the multiplexer of the discrete wavelet transformation module, it is compared with the previously stored N-highest coefficients and only finally selected if it is greater than the currently stored N-highest coefficients.

It will of course be apparent to the person skilled in the art that whilst the example illustrated in Figures 2a and 2b shows only 16 registers, any number of coefficients may be selected to represent the n-highest coefficients. Typical values are the highest 30 and highest 50 coefficients, in each case with the N-highest coefficients being divided into five separate bands. In this manner, the number of wavelet coefficients finally selected is further reduced.

However, the current applicants have discovered that in using the N-highest wavelet coefficients selection scheme described above, the accuracy of the resulting analysis and crack determination can be limited, since only the wavelet coefficients with the greatest magnitudes are selected. In certain circumstances such wavelet coefficients, representing particularly strong ultrasound reflections, can be associated with false positives arising from anomalies in the pipeline being inspected other than cracking. Additionally, selecting too few coefficients, i.e. having too low a value of N, may lead to the total loss of coefficients having a lower magnitude that represent a weak signal from a feature of the pipeline that is nonetheless of potential interest. In other words, the choice of value for N is a compromise between a low value of N, representing strong data compression but potentially loosing data representing 'weak' features, and high values of N, representing weak compression but maintaining data for 'weak' features.

The present applicants have therefore sought to mitigate these difficulties by providing a new scheme of wavelet coefficient selection. According to embodiments of the present invention each ultrasonic scan is divided into M sequential time windows. For each window the wavelet coefficients generated are sorted according to their magnitudes and the N-highest coefficients are stored for each window. This produces M sorted coefficient lists. For example, taking the previous example illustrated in Figures 2a and 2b of the 16-highest coefficients being selected, and for M=6, for the same duration of scan as that represented in Figures 2a and 2b six separate ordered coefficient lists each comprising sixteen wavelet coefficients would be generated, rather than the single sixteen coefficient list according to the previous scheme illustrated by Figures 2a and 2b. However, the wavelet coefficients for each list corresponding to one of the M windows represents wavelet coefficients generated over one sixth of the time period of the total scan.

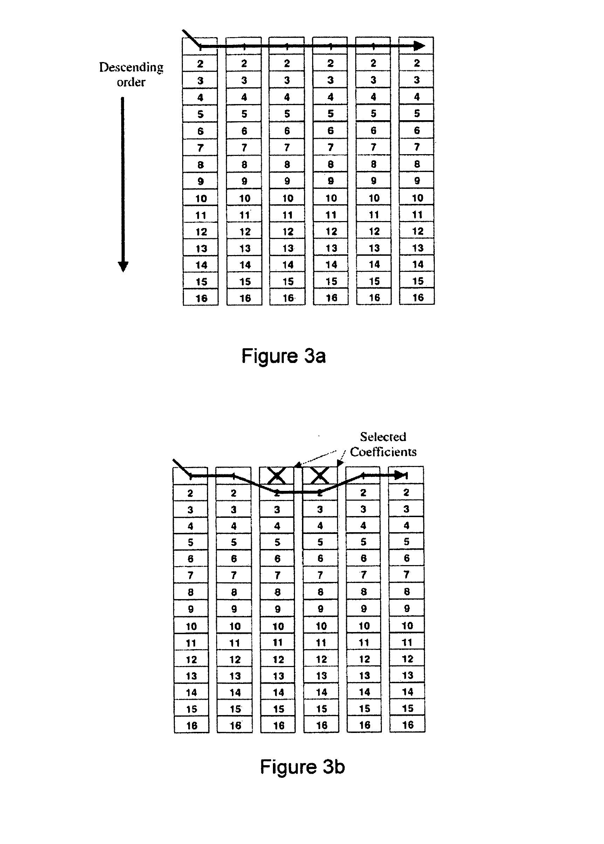

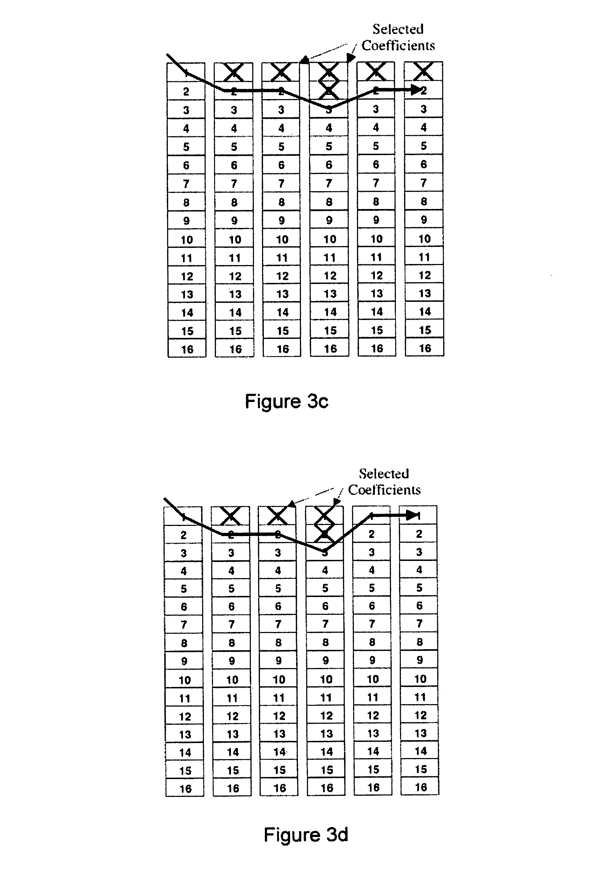

At this point in the method according to embodiments of the present invention M x N wavelet coefficients are (temporarily) stored in comparison to the wavelet coefficient scheme described above. A further wavelet coefficient selection process is therefore subsequently performed. To select a total of P coefficients from the M coefficient lists a single threshold value is first applied to each of the coefficient lists. Any coefficient having a magnitude below the threshold is discarded. The threshold can be set as a predetermined value in dependence on the type of data and applications, or in other embodiments can be set as a percentage of the R.M.S value of the data set (i.e. related to power level of the signal). Then the desired P final coefficients are selected by repeatedly selecting the highest Q (Q<P) unselected coefficients from the M sorted coefficient lists. Figures 3a-3d illustrates the P coefficients selection operation for P = 8 and Q = 2. Referring to Figure 3a, six coefficient lists are illustrated representing six time windows of the recorded scan. Each coefficient list comprises the sixteen highest wavelet coefficients for that particular time window after the initial threshold step has been completed. To select the first two (Q) of the desired P coefficients, the highest unselected coefficients from each window are compared to determine the two highest unselected coefficients. Figure 3b shows these two highest unselected coefficients as now being selected and the next comparison process, as indicated by the arrowed line, being performed by comparing the highest unselected coefficients from each of the M windows again. Figures 3c and 3d illustrate the subsequent iterations of this process such that at Figure 3d six further coefficients have been selected and the final comparison process is performed to determine the final two coefficients.

Whilst the example described above has values for M, P & Q of M=6, P=8 & Q=2, it will be appreciated that these values are unlikely to be suitable in actual implementations. Likely values for an ultrasonic data scan with 1024 samples may be M=8, P= 128, and Q=4, with the number of coefficients stored and sorted for each window increased accordingly to, for example, 64 per window.

The net effect of this coefficient selection process is that wavelet coefficients with a low absolute value, i.e. those arising from weak defect signals, are more likely to be included in the final wavelet coefficient selection, thus ensuring that those weak defects are not undesirably ignored in favour of the stringer feature signals. This is partly as a consequence of dividing each scan into multiple windows, as what would otherwise be seen as a weak feature in the entire scan may become more significant within the context of a single window.

There is a possibility that a feature of interest is located such that when the scan is divided into the M windows, the feature lies on the boundary between adjacent windows. In other words, generated wavelet coefficients representative of the feature of interest are split between separate windows. Depending on the values of the coefficients associated with the feature relative to the values of the other coefficients in the same window, this may result in the coefficients associated with the feature not being selected when it otherwise may be desirable for them to be selected. In some further embodiments of the present invention this is addressed by arranging for the windows to have a temporal overlap, such that those coefficients generated by features located within the overlap period will be allocated to two temporally adjacent windows, i.e the same coefficients will occur twice in the separate windows. This increases the likely hood that all the coefficients associated with a particular feature will be included in at least one of the windows.

The time-windowing wavelet coefficient selection of the present invention can be implemented using M+1 highest-N wavelet coefficient selection modules as described with reference to Figures 2a and 2b, with one module being used to sort the coefficients for each time window and a further module for selecting the highest Q coefficients at each iteration. The resources required for the time-windowing wavelet coefficient selection procedure of the present invention is therefore M+1 times more than that of the equivalent highest-N wavelet coefficient selection scheme, but the resulting selected wavelet coefficients constitute a better balance of coefficient allocations for strong and weak defects/features.

## Claims

1. A method of data compression comprising,
dividing a stream of sequentially received-generated data coefficients into multiple sets of data coefficients, each set of the data coefficients representing a time period and for each set selecting N data coefficients having the greatest magnitude and ordering the N data coefficients according to their magnitude;
for each N ordered data coefficients, selecting a subset of data coefficients having a magnitude greater than a threshold value;
comparing the data coefficient with the greatest magnitude from each subset to one another and selecting the Q largest data coefficients;
repeating the previous comparison step excluding the previously selected Q data coefficients until a total of P data coefficients have been selected, where N > P > Q.

2. A method of data compression according to claim 1, wherein the threshold value is a predetermined value.

3. A method of data compression according to claim 1, wherein the threshold value is a percentage of the R.M.S value of the data coefficients.

4. A method of data comparison according to any preceding claim, wherein any two of the sets of data coefficients representing sequential time periods may have a plurality of data coefficients in common, the common coefficients in each set representing an overlapping portion of the time periods.

5. A method of data compression according to any preceding claim, wherein said data coefficients comprise wavelet coefficients.

6. A method of data compression according to claim 5, wherein said wavelet coefficients are generated by performing a Discrete Wavelet Transformation on a digital data stream.

7. A method of data compression according to claim 6, wherein the digital data stream is derived from the output of one or more electro-magnetic sensors.

8. A method of data compression according to clam 7, wherein said electro-magnetic sensors comprise ultrasonic or magnetic sensors.

9. A method of data compression according to claim 7 or 8, wherein said digital data stream is generated by a pipeline inspection tool having one or more of said sensors.

10. A computer program comprising computer executable instructions that when executed by a computer cause the computer to perform the method of any one of claims 1 to 8.

11. Apparatus for performing data compression comprising a data processor arranged to perform the method of any one of the claims 1 to 9.

12. A pipeline inspection tool comprising at least one electro-magnetic sensor assembly arranged to generate a digital data stream, a coefficient module arranged to receive the digital data stream and output a stream of data coefficients, and a data processor arranged to perform the data compression method of any one of claims 1 to 9.
